# FASCICULE DE BREVET EUROPEEN

(11) **EP 3 561 523 B1**
(45) Date de publication et mention de la délivrance du brevet: **12.10.2022**
(21) Numéro de dépôt: 19162300.8
(22) Date de dépôt: 12.03.2019
(51) Int. Cl.: G01R 15/18, G01R 35/00, G01R 19/00, G01R 21/00, G01R 31/327, G01R 31/52, G01R 31/62, G01R 31/72

(54) **APPAREIL ÉLECTRIQUE COMPORTANT DES MOYENS DE TEST D'UN TRANSFORMATEUR DE COURANT TESTABLE**
ELEKTRISCHE VORRICHTUNG, DIE MITTEL ZUM PRÜFEN EINES PRÜFBAREN STROMWANDLERS UMFASST
ELECTRICAL DEVICE INCLUDING MEANS FOR TESTING A TESTABLE CURRENT TRANSFORMER

(30) Priorité: 27.04.2018 FR 1853705
(43) Date de publication de la demande: 30.10.2019
(73) Titulaire: Schneider Electric Industries SAS, 92500 Rueil Malmaison (FR)
(72) Inventeur: URANKAR, Lionel, 38050 GRENOBLE (FR)
(74) Mandataire: Schneider Electric

(56) Documents cités:
- EP-A1- 0 573 350
- EP-A1- 1 936 771
- EP-A1- 2 653 875
- EP-A1- 3 171 182
- EP-A1- 3 290 930
- EP-A2- 0 838 686
- DE-A1- 19 825 383
- FR-A1- 2 783 085
- FR-A1- 2 830 692
- FR-A1- 2 870 040
- FR-A1- 2 897 470
- US-A1- 2004 178 875
- US-A1- 2013 057 307
- US-A1- 2015 028 850
- US-A1- 2015 355 273
- US-A1- 2016 320 434
- US-A1- 2017 356 935
- US-B1- 6 313 623
- NURMANSAH ARY P ET AL: "Design and testing PCB Rogowski-coil current sensor for high current application", 2017 INTERNATIONAL CONFERENCE ON HIGH VOLTAGE ENGINEERING AND POWER SYSTEMS (ICHVEPS), IEEE, 2 octobre 2017 (2017-10-02), pages 493-497, XP033286665, DOI: 10.1109/ICHVEPS.2017.8225897
- IBRAHIM MOHAMED E ET AL: "Power frequency AC voltage measurement based on double wound Rogowski coil", HIGH VOLTAGE, THE INSTITUTION OF ENGINEERING AND TECHNOLOGY, MICHAEL FARADAY HOUSE, SIX HILLS WAY, STEVENAGE, HERTS. SG1 2AY, UK, vol. 2, no. 2, 1 juin 2017 (2017-06-01), pages 129-135, XP006062191, ISSN: 2397-7264, DOI: 10.1049/HVE.2016.0091
- PAULUS SIMON ET AL: "Continuous calibration of Rogowski coil current transducer", ANALOG INTEGRATED CIRCUITS AND SIGNAL PROCESSING, SPRINGER NEW YORK LLC, US, vol. 89, no. 1, 19 mai 2016 (2016-05-19), pages 77-88, XP036053632, ISSN: 0925-1030, DOI: 10.1007/S10470-016-0764-7 [extrait le 2016-05-19]

## Description

### DOMAINE TECHNIQUE

La présente invention concerne un transformateur de courant de type Rogowski destiné à la mesure d'un courant circulant dans un conducteur de courant formant un circuit primaire. Le transformateur de courant comporte un enroulement secondaire de mesure et un enroulement secondaire de test pour induire un courant électrique de test dans l'enroulement secondaire de mesure.

L'invention concerne également un appareil électrique comportant un tel transformateur de courant ainsi que des moyens de test du transformateur de courant.

### ETAT DE LA TECHNIQUE

Des capteurs de courant sont utilisés dans les appareils de mesure du courant, de la puissance ou de l'énergie électrique ainsi que dans les appareils de protection ou de contrôle des installations de distribution électrique comme les disjoncteurs, contacteurs, sectionneurs ou encore compteurs électriques. Parmi les capteurs de courant utilisés figure le capteur de Rogowski. Ce type de capteur comprend un support en matériau amagnétique placé autour d'un conducteur électrique dans lequel circule le courant à mesurer. Un fil conducteur est bobiné sur le support pour former un enroulement secondaire. L'ensemble forme un transformateur de courant où la ligne de courant constitue un enroulement primaire et où l'enroulement secondaire fournit un signal de mesure représentatif de la dérivée du courant circulant dans la ligne de courant. Un capteur de Rogowski offre les avantages d'un coût moins élevé et d'un encombrement plus faible qu'un capteur de type magnétique à cause de l'absence de circuit magnétique et donc l'absence de phénomène de saturation en particulier pour des amplitudes élevées du courant à mesurer. En revanche le niveau de signal délivré est significativement plus faible qu'un transformateur comportant un circuit magnétique.

Quand un capteur de courant est utilisé dans un appareil destiné à la protection d'un réseau électrique, il est important de s'assurer périodiquement que le capteur fonctionne correctement. En effet, si le capteur est déficient, la protection du réseau électrique n'est plus assurée par l'appareil. De plus, les moyens de vérification du fonctionnement ne doivent pas perturber le signal de mesure. Le document FR 2 830 692 A1 décrit un dispositif de test d'un capteur de courant consistant à vérifier que deux capteurs de courant associés à une même ligne de courant débitent simultanément. Cette invention est particulièrement intéressante quand on dispose d'un capteur de courant comprenant un circuit magnétique destiné à fournir une alimentation et un capteur de Rogowski pour fournir un signal de mesure. Cette solution est attractive pour des appareils de forte puissance mais est plus difficile à mettre en œuvre dans les appareils de faible calibre, le coût et la place disponible étant limités. Le document WO 99/62157 A1 décrit un capteur pouvant être testé en cours de fonctionnement. Pour cela, l'enroulement secondaire fait partie d'un circuit oscillant haute fréquence, circuit étant excité par un enroulement auxiliaire. Un diagnostic du fonctionnement du transformateur de courant est basé sur la consommation d'énergie du circuit oscillant. Cette solution est attractive pour un test en fonctionnement établi mais peut demander un temps de stabilisation incompatible avec le temps de réaction très court demandé à un dispositif de protection étant fermé sur un défaut électrique. Le document US 2013/0057307 A1 décrit un moyen pour appliquer une tension continue au bobinage. Une mesure d'offset aux bornes de l'enroulement secondaire traduit une coupure de l'enroulement. Cette solution est très simple et économique cependant l'élimination de l'offset présent sur le signal de mesure peut demander un temps de traitement, là aussi, incompatible avec le temps de réaction demandé à un dispositif de protection. De plus, il est difficile d'éliminer complètement l'offset dans le cas d'une mesure différentielle d'un faible signal continu aux bornes de l'enroulement.

Les documents EP1936771 A1, EP0573350 A1, FR2783085 A1, EP2653875 A1, US 2015/355273 A1 , US2015/028850 A1 ou FR2897470 A1 décrivent des capteurs de courant ou des dispositifs de test de tels capteurs.

### EXPOSE DE L'INVENTION

L'invention a pour but de proposer un transformateur de courant de Rogowski destiné préférentiellement à un appareil de protection de faible puissance, le transformateur de courant pouvant être testé sans introduire de perturbations dans la mesure du courant et sans affecter le temps de réponse de l'appareil.

Pour cela, l'invention concerne un appareil selon la revendication 1. Il comprend un transformateur de courant de type Rogowski destiné à la mesure d'un courant circulant dans un conducteur de courant formant un circuit primaire, le transformateur de courant comportant un enroulement secondaire de mesure adapté pour entourer le conducteur de courant et un enroulement secondaire de test pour induire un signal de test dans l'enroulement secondaire de mesure quand des impulsions de test sont appliquées à l'enroulement secondaire de test.

Dans un premier mode de réalisation, l'enroulement secondaire de mesure est bobiné en suivant un premier axe d'enroulement circulaire, l'enroulement secondaire de test est bobiné en suivant un second axe d'enroulement circulaire, les premiers et seconds axes circulaires ayant un même centre et étant disposés dans un même plan.

Dans un second mode de réalisation, l'enroulement secondaire de mesure est composé d'au moins un premier tronçon d'enroulement de mesure, l'enroulement secondaire de test est composé d'au moins un premier tronçon d'enroulement de test, les premiers tronçons d'enroulement de mesure et de test ayant un même axe d'enroulement.

Avantageusement :
- l'enroulement secondaire de mesure est formé d'au moins une première portion réalisée au moyen d'un premier support, et d'une seconde portion réalisée au moyen d'un second support, la seconde portion étant bobinée en sens inverse de la première portion, la première et la seconde portion d'enroulement étant reliées en série,
- l'enroulement secondaire de test est formé d'au moins une première portion réalisée au moyen du premier support et d'une seconde portion réalisée au moyen du second support, la seconde portion étant bobinée en sens inverse de la première portion, la première et la seconde portion d'enroulement secondaire de test étant reliées en série, et
- le premier et le second support sont disposés côte-à-côte de façon à ce que les axes d'enroulement de la première portion et de la seconde portion d'enroulement secondaire de mesure soient parallèles et que les axes d'enroulement de la première portion et de la seconde portion d'enroulement secondaire de test soient parallèles.

Préférentiellement, le premier et le second support sont réalisés au moyen de circuit imprimé.

L'invention porte ainsi sur un appareil électrique comportant :
- un transformateur de courant tel que décrit précédemment,
- un circuit de traitement, connecté à l'enroulement secondaire de mesure du transformateur de courant, pour fournir un signal représentatif du courant électrique,
- un premier circuit de filtrage du signal représentatif du courant électrique, connecté au circuit de traitement, pour fournir un premier signal filtré dans une première bande de fréquences,
- un circuit générateur d'impulsions connecté à l'enroulement secondaire de test du transformateur de courant pour générer des impulsions de test dans l'enroulement secondaire de test à une fréquence de test prédéfinie contenue dans une deuxième bande de fréquences, et
- un deuxième circuit de filtrage du signal représentatif du courant électrique, connecté au circuit de traitement, pour fournir un deuxième signal filtré dans la deuxième bande de fréquences.

Avantageusement, la deuxième bande de fréquences est supérieure à la première bande de fréquences.

Avantageusement, le circuit de traitement échantillonne le signal représentatif du courant électrique à une fréquence d'échantillonnage supérieure à la fréquence de test.

De préférence, la fréquence d'échantillonnage est sensiblement égale à trois fois la fréquence de test.

De préférence, la fréquence de test est comprise entre 800 et 2000 Hz.

Avantageusement, l'appareil électrique comporte également un circuit de surveillance, connecté au deuxième circuit de filtrage, pour recevoir le deuxième signal filtré et pour générer une alerte quand l'amplitude du deuxième signal filtré est inférieure à un seuil d'alerte prédéfini.

Préférentiellement, les impulsions de test sont générées par dérivation d'un signal carré émis par un générateur de signal carré.

Avantageusement, un circuit de contrôle, connecté à l'enroulement secondaire de test, active un signal de contrôle quand la forme de la tension aux bornes de l'enroulement secondaire de test est identique à la forme du signal carré émis pas le générateur de signal carré.

Avantageusement, le circuit de surveillance est connecté au circuit de contrôle pour recevoir le signal de contrôle et pour générer l'alerte quand le signal de contrôle est actif.

De préférence, l'appareil électrique décrit précédemment comporte également :
- un interrupteur de courant pour établir ou pour interrompre la circulation d'un courant électrique dans, au moins, un conducteur de courant,
- un actionneur pour actionner l'ouverture de l'interrupteur de courant,
- un circuit de protection, connecté au premier circuit de filtrage pour recevoir le premier signal filtré (P), et comportant au moins un seuil de déclenchement, le circuit de protection activant l'actionneur quand le premier signal filtré est supérieur au seuil de déclenchement.

En variante, l'appareil électrique comporte également un circuit de mesure, connecté à un troisième circuit de filtrage pour recevoir un troisième signal filtré et pour fournir une mesure du troisième signal filtré.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 est une représentation schématique de l'implantation de plusieurs enroulements d'un transformateur de courant, les enroulements étant disposés, selon un premier mode de réalisation, selon des axes d'enroulement circulaires sur un support ;
- la figure 2 est une représentation des enroulements représentés en figure 1 d'une façon étirée afin de montrer la différence de position des axes d'enroulement de chacun des enroulements ;
- la figure 3 est une représentation schématique d'enroulements du transformateur de courant formés de plusieurs tronçons suivant des axes d'enroulement rectilignes selon un second mode de réalisation ;
- la figure 4 est une représentation d'une succession de plusieurs tronçons d'enroulements représentés en figure 3 pour montrer la disposition des différents tronçons d'enroulements selon un axe particulier ainsi que leur connexion électrique ;
- les figures 5a et 5b représentent des modes de réalisation d'enroulements circulaires du transformateur de courant au moyen de plusieurs portions d'enroulement disposées sur plusieurs supports ;
- les figures 6a et 6b représentent le transformateur de courant, selon le second mode de réalisation, les enroulements étant formés de plusieurs portions disposées sur plusieurs supports, chaque portion étant constituée d'une succession de plusieurs tronçons d'enroulements ;
- la figure 7 est une représentation synoptique d'un transformateur de courant de l'invention et des circuits de traitement utilisés pour mesurer un courant et pour tester le transformateur selon un mode de réalisation préférentiel ;
- la figure 8 est une représentation spectrale des signaux à mesurer, d'un signal de test et d'une fréquence d'échantillonnage des signaux ;
- la figure 9 est un schéma synoptique d'un générateur de signaux de test du transformateur de courant ;
- la figures 10a, 10b et 10c représentent des signaux internes ou émis par le générateur de signaux de test représenté en figure 9, et
- la figure 11 est une représentation synoptique d'un appareil électrique de protection selon un mode de réalisation préférentielle.

### DESCRIPTION DETAILLEE DE MODES DE REALISATION PREFERES

L'invention porte sur un transformateur de courant de type Rogowski destiné à la mesure d'un courant Ip circulant dans un conducteur de courant 2. Le transformateur de courant est composé d'un enroulement secondaire de mesure 31 adapté pour entourer le conducteur de courant 2, ledit conducteur formant un circuit primaire. Un courant Ip circulant dans le conducteur de courant 2 va induire un flux électromagnétique dans l'enroulement secondaire de mesure 31, lequel flux génère un signal, un courant ou une tension selon le type de charge utilisée, dans l'enroulement secondaire 31.

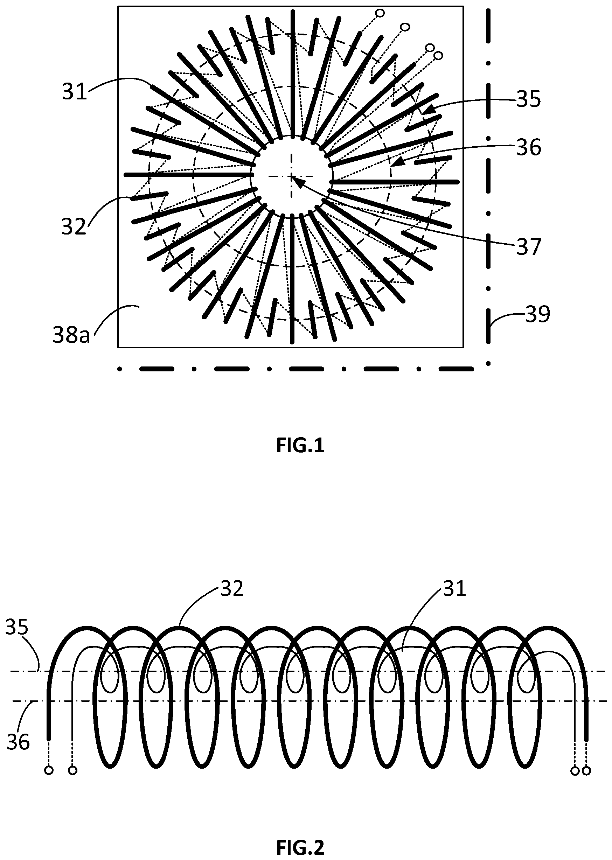

La figure 1 est une représentation schématique de l'implantation de l'enroulement secondaire de mesure 31 selon un premier mode de réalisation. L'enroulement secondaire de mesure 31 est disposé selon un premier axe d'enroulement circulaire 36 autour d'un centre 37. L'enroulement de mesure 31 est formé sur un premier support 38a. L'enroulement secondaire de mesure 31 est formé de spires représentées en traits continu lorsque la spire est sur une face visible du premier support 38a et représentées en traits pointillés lorsque la spire est sur une face invisible ou opposée du premier support 38a. Les spires sont disposées régulièrement en suivant des rayons du cercle formé par le premier axe d'enroulement 36 de centre 37. Pour maximiser le signal délivré par l'enroulement secondaire de mesure, les spires de l'enroulement secondaire doivent avoir une surface la plus grande possible. Les spires doivent donc s'étendre du plus près du centre 37 au plus près du bord du premier support 38a. Il faut noter que le centre 37 est aussi le passage du conducteur de courant 2 et qu'il convient de laisser l'espace nécessaire au passage de ce conducteur de courant 2.

Pour tester la continuité de l'enroulement secondaire de mesure 31, un enroulement secondaire de test 32 est disposé en étroite association avec l'enroulement secondaire de mesure 31. Compte tenu, d'une part, de la disposition circulaire des spires de l'enroulement secondaire de mesure 31, et, d'autre part, de la nécessité de maximiser le nombre de spires de l'enroulement secondaire de mesure 31 pour obtenir un maximum de signal, il n'est pas possible de disposer de spires de l'enroulement secondaire de test 32 à proximité du centre 37. En revanche, il est possible de disposer au moins une spire de l'enroulement secondaire de test 32 dans un intervalle entre deux spires consécutives en périphérie de l'enroulement de mesure 31 comme représenté en figure 1. Les spires de l'enroulement secondaire de test 32 sont bobinées en suivant un second axe d'enroulement circulaire 35 de même centre 37 que l'axe d'enroulement de l'enroulement de mesure 36 mais de diamètre supérieur. Avantageusement, les premiers et seconds axes circulaires 35, 36 sont disposés dans un même plan 39. On obtient ainsi un couplage serré entre les spires de l'enroulement de test 32 et les spires de l'enroulement de mesure 31 permettant une transmission de flux électromagnétique satisfaisante entre l'enroulement de test 32 et l'enroulement de mesure 31 bien que la surface de chaque spire de l'enroulement secondaire de test 32 soit inférieure à la surface d'une spire de l'enroulement de mesure 31. La figure 2 représente les enroulements de mesure et de test d'une façon étirée afin de montrer le décalage de position des axes d'enroulement 35, 36 de chacun des enroulements 31, 32, le couplage serré entre chaque spire de l'enroulement de mesure et chaque spire de l'enroulement de test et enfin la différence de surface d'une spire de l'enroulement de test par rapport à une spire de l'enroulement de mesure.

Le couplage entre l'enroulement de test 32 et l'enroulement de mesure 31 s'effectue dans l'air, des impulsions de test 61 appliquées à l'enroulement de test 32 génèrent un flux électromagnétique qui induit un signal dans l'enroulement secondaire de mesure 31. L'efficacité d'un tel couplage est inférieure à un couplage réalisé au moyen d'un circuit magnétique mais, en contrepartie, la réalisation de l'enroulement de mesure 31 associé à l'enroulement de test 32 est très compacte et économique.

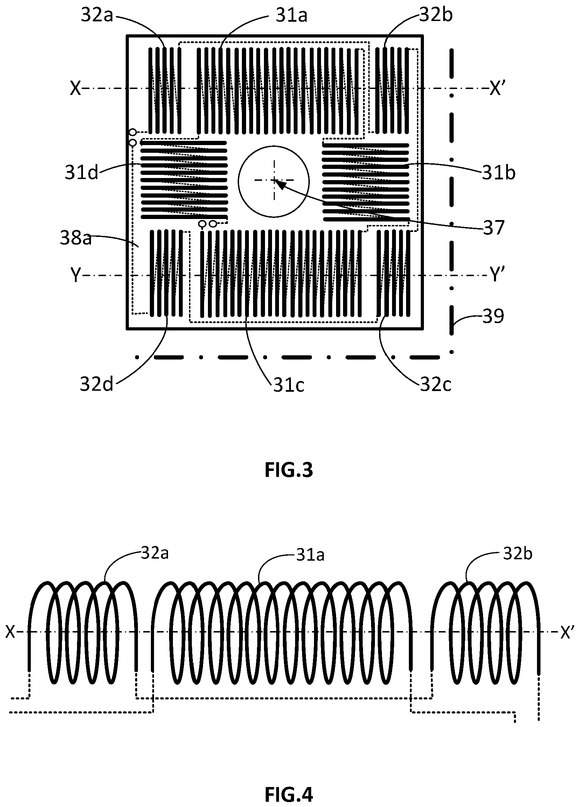

Avantageusement, pour maximiser la surface des spires des enroulements de mesure 31 et de test 32 et pour utiliser l'ensemble de la surface du premier support 38a, tout particulièrement quand celui-ci est de forme polygonale, les enroulements de mesure 31 et de test 32 sont formés de plusieurs tronçons enroulés en suivant des axes rectilignes, orientés préférentiellement parallèlement aux côtés d'un polygone. Cette disposition, représentée en figure 3, permet d'occuper les zones d'angle du premier support 38a, ledit support étant, par exemple, de forme carrée. Dans ce cas, il n'est pas possible d'intercaler une spire de l'enroulement de test 32 entre deux spires de l'enroulement de mesure 31 puisque les spires peuvent être serrées au long de l'axe rectiligne d'enroulement. Pour obtenir un très bon couplage entre l'enroulement de test 32 et l'enroulement de mesure 31, l'enroulement de test est composé d'un premier tronçon 32a aligné, selon un premier axe X-X', avec, d'une part, un premier tronçon de l'enroulement de mesure 31a et d'autre part avec un second tronçon 32b de l'enroulement de test 32. Le premier tronçon de l'enroulement de mesure 31a est donc inséré entre deux tronçons de l'enroulement de test 32 ce qui garantit un bon couplage entre les enroulements. Des troisième et quatrième tronçons d'enroulement de test 32c et 32d sont répartis de part et d'autre d'un troisième tronçon d'enroulement de mesure 31c selon un axe rectiligne Y-Y' orienté selon un côté du premier support 38a. Un deuxième et un quatrième tronçons d'enroulement de mesure 31b et 31d sont implantés selon des axes perpendiculaires aux axes X-X' ou Y-Y' entre les premier et troisième tronçons d'enroulement de mesure 31a et 31c. Les axes d'enroulement des tronçons d'enroulement de test 32 et de mesure 31 sont situés dans un même plan 39. Les tronçons composant l'enroulement de mesure 31 sont disposés au plus près du centre 37 du capteur, les tronçons composant l'enroulement de test 32 sont disposés dans les zones d'angle.

La figure 4 une représentation du premier tronçon 31a de l'enroulement de mesure 31 encadré par les premier et deuxième tronçons d'enroulement 32a et 32b de l'enroulement de test 32. Les premier et deuxième tronçons d'enroulement 32a et 32b de l'enroulement de test 32 sont électriquement connectés en série. L'enroulement de mesure 31 est constitué des premiers, deuxièmes, troisièmes et quatrièmes tronçons d'enroulement de mesure 31a, 31b, 31c, 31d reliées en série. L'enroulement de test 32 est constitué des premiers, deuxièmes, troisièmes et quatrièmes tronçons d'enroulement de test 32a, 32b, 32c, 32d reliés en série.

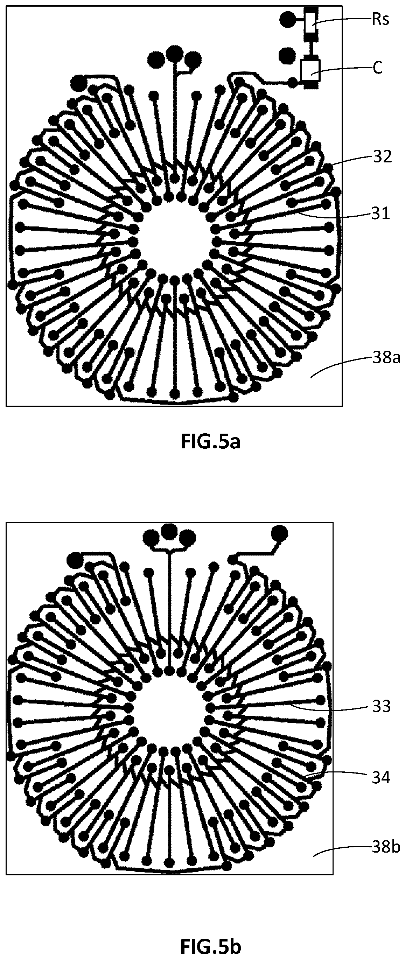

La réalisation d'un transformateur de Rogowski mentionne classiquement une réalisation d'une spire dite « de retour » afin de compenser la boucle parasite créée par l'enroulement de mesure. Une autre façon de compenser la boucle parasite est de réaliser l'enroulement de mesure en un nombre pair de portions, une première portion étant enroulée dans un premier sens, une seconde portion étant enroulée dans un second sens, inverse du premier sens. Les figures 5a et 5b illustrent un mode de réalisation d'enroulements circulaires du transformateur de courant au moyen de plusieurs portions d'enroulement disposées sur plusieurs supports. Une première portion d'enroulement de mesure 31 et une première portion d'enroulement de test 32 sont disposées sur un premier support 38a de façon décrite précédemment en figure 1 et figure 2. Une seconde portion d'enroulement de mesure 33 et une seconde portion d'enroulement de test 34 sont disposées sur un second support 38b. La seconde portion d'enroulement de mesure 33 et la seconde portion d'enroulement de test 34 sont bobinées respectivement en sens inverse du bobinage de la première portion d'enroulement de mesure 31 et de la première portion d'enroulement de test 34 : par exemple, si la première portion d'enroulement de mesure 31 est bobinée dans le sens horaire par rapport au centre 37 du premier axe d'enroulement 36, alors la seconde portion d'enroulement de mesure 33 est bobinée dans le sens anti-horaire. De la même façon, la première portion d'enroulement de test 32 est bobinée en sens inverse du sens de bobinage de la seconde portion d'enroulement de test 34. D'une part, la première portion d'enroulement de mesure 31 et la seconde portion d'enroulement de mesure 33 sont connectées en série et, d'autre part, la première portion d'enroulement de test 32 et la seconde portion d'enroulement de test 34 sont connectées en série. Les premiers et second supports 38a et 38b sont disposés parallèlement côte-à-côte de manière à ce que les axes d'enroulement de tous les enroulements soient situés dans des plans parallèles ou confondus et que le centre 37 des axes d'enroulement soit le même. On obtient ainsi un enroulement secondaire de mesure formé de deux portions d'enroulements proches, disposés dans des plans parallèles et bobinés en sens inverse l'un par rapport à l'autre. Cette disposition apporte une excellente immunité aux champs électromagnétiques perturbateurs externes. Préférentiellement les premiers et second supports 38a et 38b sont des circuits imprimés et les enroulements de mesure et de test sont obtenus par gravure ou sérigraphie de circuit imprimé.

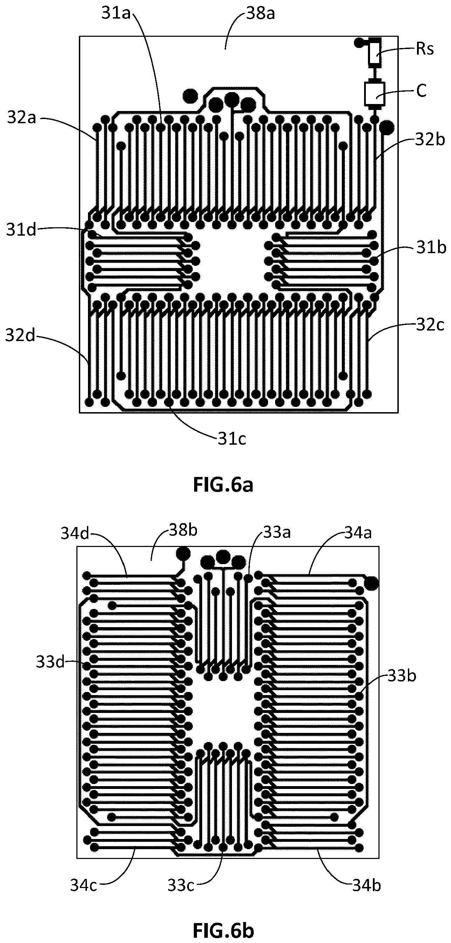

Les figures 6a et 6b illustrent un mode préférentiel de réalisation d'enroulements pour un transformateur de courant de forme polygonale, au moyen de plusieurs portions d'enroulement enroulées en suivant des axes rectilignes, orientés parallèlement aux côtés d'un polygone, sur des premiers et second supports 38a et 38b. Ce mode de réalisation correspond à un transformateur de courant tel que décrit par la figure 3 et réalisé de façon équivalente au transformateur circulaire des figures 5a et 5b. Comme représenté sur la figure 6a, une première portion de l'enroulement de mesure 31 est réalisée au moyen de quatre tronçons d'enroulement rectilignes 31a, 31b, 31c et 31d sur le premier support 38a. De même une première portion de l'enroulement de test 32 est réalisée au moyen de quatre tronçons d'enroulement rectilignes 32a, 32b, 32c et 32d. Comme représenté sur la figure 6b, une seconde portion de l'enroulement de mesure 33 est réalisée au moyen de quatre tronçons d'enroulement rectilignes 33a, 33b, 33c et 33d sur le second support 38b. De même une seconde portion de l'enroulement de test 34 est réalisée au moyen de quatre tronçons d'enroulement rectilignes 34a, 34b, 34c et 34d. L'orientation des spires de la première portion de l'enroulement de mesure 31 et de la seconde portion de l'enroulement de mesure 33 est avantageusement telle que décrite dans le document EP 3 171 182 A1, c'est-à-dire que, dans les zones d'angles, les axes de bobinage des enroulements sont orthogonaux. Cette disposition permet une excellente immunité aux champs électromagnétiques perturbateurs externes tout en permettant une occupation maximale de la surface des premier et second supports 38a, 38b. L'immunité aux champs parasites externes peut être accentuée en réalisant les premier et second supports 38a, 38b à partir d'une même plaque de circuit imprimé.

Un transformateur de Rogowski 3 tel que décrit précédemment est destiné à fournir un signal représentatif d'un courant électrique Ip circulant dans un conducteur de courant 2. Le transformateur est implanté dans un appareil électrique 5, tel qu'un disjoncteur, un contacteur ou un appareil de mesure, afin que l'appareil électrique exécute des actions de protection, de commande, d'alerte et/ou de mesure en fonction de l'amplitude du courant Ip circulant dans le conducteur de courant 2.

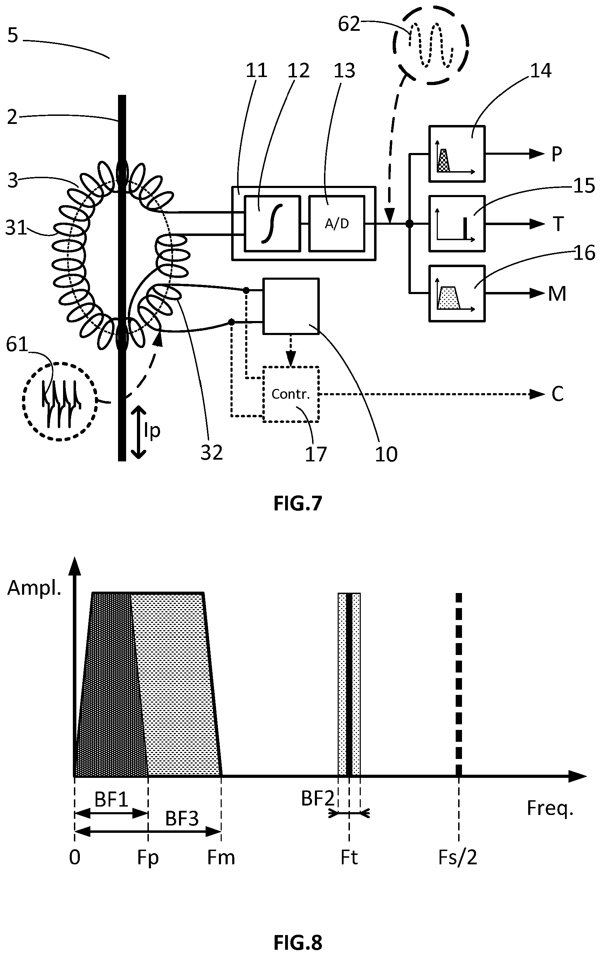

La figure 7 est une représentation synoptique d'un transformateur de courant 3 de l'invention et des circuits de traitement utilisés pour mesurer le courant Ip circulant dans le conducteur de courant 2 et pour exécuter un test du fonctionnement du transformateur 3. Le conducteur 2 assure une partie de la continuité électrique entre, par exemple, une source d'énergie électrique connectée à une charge consommatrice d'énergie électrique. Le courant Ip est, dans ce cas, le courant circulant dans la charge. L'appareil électrique comporte un circuit de traitement 11, connecté à l'enroulement secondaire de mesure 31, pour fournir un signal 62 représentatif du courant électrique Ip circulant dans le conducteur de courant 2. Le circuit de traitement 11 comporte un circuit intégrateur 12 et un convertisseur analogique numérique 13 pour transformer le signal analogique délivré par l'intégrateur 12 en un signal numérique. En variante, la position du convertisseur analogique numérique 13 et du circuit intégrateur 12 peut être intervertie pour que le convertisseur 13 convertisse le signal délivré par l'enroulement secondaire de mesure 31 en un signal numérique délivré à un intégrateur 12 de technologie numérique. Un premier circuit de filtrage 14 est connecté au circuit de traitement 11 pour fournir un premier signal filtré P dans une première bande de fréquences BF1, comprise entre quelques Hertz et la fréquence Fp. Préférentiellement, Fp est comprise entre 60 et 250 Hz. Cette bande passante est bien adaptée pour exécuter une fonction de protection d'un réseau électrique. Un circuit générateur d'impulsions 10 est connecté à l'enroulement secondaire de test 32 pour générer des impulsions de test 61 dans l'enroulement secondaire de test 32 à une fréquence de test prédéfinie Ft contenue dans une deuxième bande de fréquences BF2. La deuxième bande de fréquences BF2 est supérieure à la première bande de fréquences BF1 c'est-à-dire que la plus haute fréquence Fp de la première bande de fréquences BF1 est inférieure à la plus basse fréquence de la deuxième bande de fréquences BF2. Il n'y a donc pas de chevauchement des fréquences ainsi que représenté en figure 8. Lors d'une phase de test du transformateur de courant 3, le circuit générateur d'impulsions 10 génère des impulsions de test 61 dans l'enroulement secondaire de test 32 ce qui induit un signal de test dans l'enroulement secondaire de mesure 31. Puisque la fréquence Ft des impulsions de test 61 est située dans la deuxième bande de fréquence BF2 séparée de la première bande de fréquence BF1, il est possible de détecter un signal de fréquence Ft en sortie du circuit de traitement 11. Pour cela, un deuxième circuit de filtrage 15 du signal représentatif du courant électrique 62 est connecté au circuit de traitement 11, pour fournir un deuxième signal T, filtré dans la deuxième bande de fréquences BF2. Préférentiellement la fréquence Ft des impulsions de test est centrée dans la deuxième bande de fréquence BF2.

Préférentiellement, le convertisseur analogique numérique 13 échantillonne le signal délivré par l'enroulement secondaire de mesure 31 à une fréquence d'échantillonnage Fs, supérieure à la fréquence de test Ft. Le processus d"échantillonnage provoque un phénomène de repliement de spectre du signal échantillonné : pour éviter toute perturbation de la mesure par ce phénomène, il est impératif que la plus haute des fréquences traitées soit inférieure à la moitié de la fréquence d'échantillonnage Fs. La fréquence d'échantillonnage Fs est choisie sensiblement égale à trois fois la fréquence de test Ft. Ainsi, toutes les fréquences contenues dans les premières et deuxièmes bandes de fréquence BF1 et BF2 sont significativement inférieures à Fs/2 et le phénomène de repliement de spectre est réduit. Préférentiellement, la fréquence de test Ft est comprise entre 1000 et 2000 Hz pour une fréquence d'échantillonnage comprise entre 3 000 Hz et 7 000 Hz.

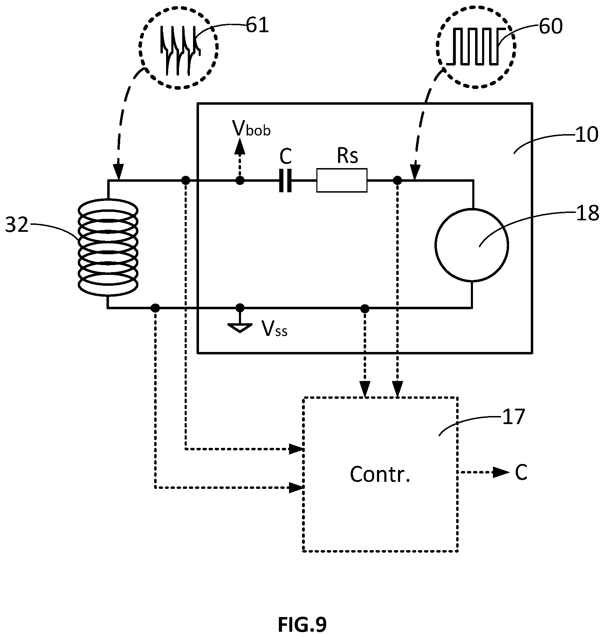

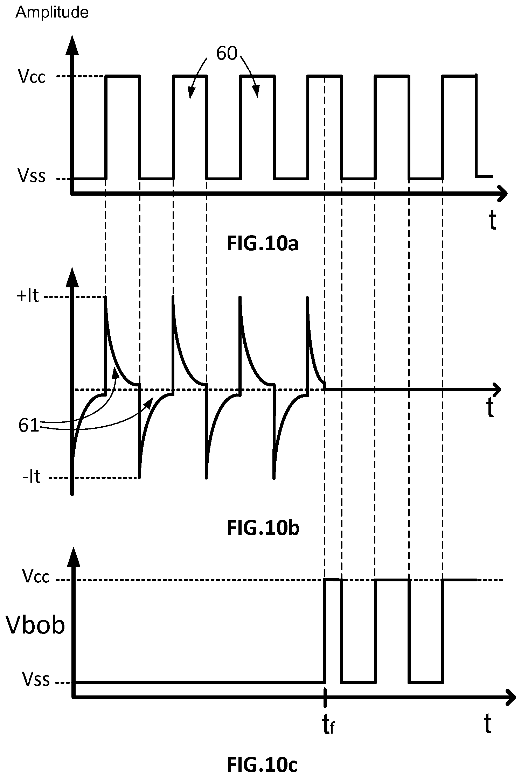

Le circuit générateur d'impulsions 10 est connecté à l'enroulement secondaire de test 32 pour générer des impulsions de test 61 dans l'enroulement secondaire de test 32. Un schéma synoptique du générateur de signaux de test 10 est représenté en figure 9. Un générateur de signal carré 18 est connecté en série avec une résistance série Rs, un condensateur C et l'enroulement secondaire de test 32. Une borne du générateur de signal carré 18 est connectée à un potentiel de référence Vss. Une tension Vbob est mesurée aux bornes de l'enroulement secondaire de test 32. Le générateur de signal carré 18 génère un signal carré 60 d'amplitude Vcc par rapport au potentiel de référence Vss. Afin de limiter la puissance utilisée pour effectuer le test du transformateur de courant 3, le signal émis par le générateur 18 est dérivé par le condensateur C pour devenir des impulsions de test 61 d'amplitude +It et -It appliquées aux bornes de l'enroulement secondaire de test 32. La figure 10b représente la forme des impulsions de courant de test 61 circulant dans l'enroulement secondaire de test quand le générateur de signal carré 18 émet un signal carré 60.

En option, un circuit de contrôle 17, connecté aux bornes de l'enroulement secondaire de test 32, contrôle la présence des impulsions de test 61 aux bornes de l'enroulement secondaire de test 32. Le signal carré 60 émis par le générateur 18 est représenté en figure 10a. Quand l'enroulement secondaire 32 est opérationnel et compte tenu d'une faible impédance de cet enroulement, la tension Vbob aux bornes de l'enroulement est faible, comme illustré par la courbe de la figure 10c entre le temps t= 0 et t = tf. En revanche, si à l'instant tf, l'enroulement secondaire de test 32 est coupé, la tension aux bornes de l'enroulement secondaire de test 32 a la même forme que le signal carré 60 généré par le générateur 18, ainsi que représenté sur la courbe de la figure 10c pour un temps t ≥ tf. Le circuit de contrôle 17 compare la forme de la tension Vbob aux bornes de l'enroulement secondaire de test 32 avec la forme du signal carré 60 généré par le générateur 18 et active un signal de contrôle C quand la forme de la tension Vbob est semblable à la forme du signal carré 60 généré par le générateur 18. Le circuit de surveillance 54 est connecté au circuit de contrôle 17 pour recevoir le signal de contrôle C et pour générer l'alerte AL quand le signal de contrôle C est actif.

En variante, des composants discrets et/ou des circuits analogiques tels que des amplificateurs opérationnels peuvent être utilisés pour effectuer le traitement du signal et le filtrage.

Pour vérifier le bon fonctionnement transformateur de courant de Rogowski, l'appareil électrique 5 comporte un circuit de surveillance 54, connecté au deuxième circuit de filtrage 15 pour recevoir le deuxième signal filtré T. Le circuit de surveillance 54 génère une alerte AL quand l'amplitude du deuxième signal filtré T est inférieure à un seuil d'alerte Sal prédéfini. L'opérateur peut intervenir préventivement quand un défaut apparait dans l'appareil électrique 5. Une phase de test du transformateur de courant, correspondant à la génération d'un train d'impulsions de test 61 dans l'enroulement secondaire de test 32, peut être ponctuelle, périodique ou permanente. Le traitement du signal 62 représentatif du courant électrique Ip, sur lequel sont superposées les impulsions de test, est permanent.

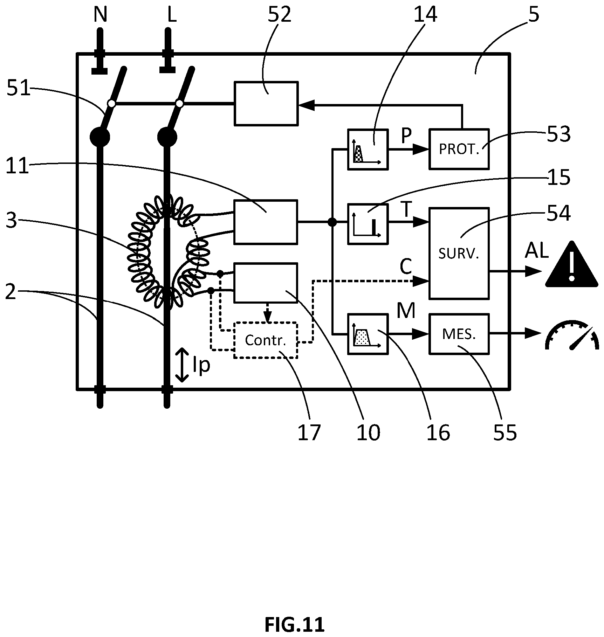

L'appareil électrique 5 tel que décrit précédemment peut être un appareil de protection électrique tel qu'un disjoncteur ou un interrupteur. Un tel appareil est représenté en figure 11. Dans ce cas, il comporte également :
- un interrupteur de courant 51 pour établir ou pour interrompre la circulation du courant électrique Ip dans au moins un conducteur de courant 2,
- un actionneur 52 pour actionner l'ouverture de l'interrupteur de courant 51 sur commande ou en cas de défaut dans l'installation électrique,
- un circuit de protection 53, connecté au premier circuit de filtrage 14 pour recevoir le premier signal filtré P et agencé pour activer l'actionneur 52 et
- un transformateur de courant (3) tel que décrit précédemment.

Quand un défaut apparait dans le réseau électrique ayant pour conséquence une création d'un court-circuit, le courant Ip devient très important. Le premier signal filtré P est alors supérieur à un seuil de déclenchement prédéfini Sd et le circuit de protection 53 active l'actionneur 52 pour ouvrir l'interrupteur de courant 51. Le circuit électrique est donc protégé et un opérateur peut intervenir pour éliminer le défaut. En option ou lorsque l'appareil électrique est un appareil de mesure de courant, de puissance ou d'énergie, l'appareil électrique comporte un circuit de mesure 55, connecté à un troisième circuit de filtrage 16 pour recevoir un troisième signal filtré M et pour fournir une mesure du troisième signal filtré M. Le troisième circuit de filtrage ne laisse passer que les fréquences situées dans une troisième bande de fréquence BF3. La troisième bande de fréquence BF3 est plus large que la première bande de fréquence BF1 et la première bande de fréquence BF1 est comprise dans la troisième bande de fréquence BF3. En effet, pour assurer une protection du circuit électrique, il suffit de disposer d'un signal dont la fréquence est centrée sur la fréquence du réseau électrique alors que pour effectuer une mesure du courant Ip circulant dans le conducteur de courant 2, il est utile de pouvoir mesurer également les composantes aux fréquences harmoniques de la fréquence du réseau électrique. Les première et troisième bande de fréquences BF1, BF3 correspondent aux fréquences du courant Ip alors que la deuxième bande BF2 correspond à la fréquence de test. La fréquence la plus élevée, Fm, de la troisième bande de fréquence BF3 est inférieure à la fréquence la plus basse de la deuxième bande BF2. Préférentiellement, la fréquence Fm est comprise entre 750 et 1 000 Hz.

Un appareil électrique 5 peut contenir plusieurs transformateurs de courant 3, chacun des transformateurs de courant étant destiné à la mesure du courant circulant dans chacune des phases d'un appareil destiné à fonctionner sur un réseau triphasé.

L'utilisation d'un capteur de Rogowski de l'invention, utilisé dans un appareil de protection de faible calibre ou dans un appareil de mesure est très intéressante pour des raisons de coût attractif et d'encombrement faible. De plus, le capteur peut être testé sans perturber la chaîne de mesure et sans pénaliser le temps de réponse exigé par le besoin de protection.

## Revendications

1. Appareil électrique (5) comportant un transformateur de courant (3) de type Rogowski, destiné à la mesure d'un courant (Ip) circulant dans un conducteur de courant (2) formant un circuit primaire, ledit transformateur de courant (3) comportant un enroulement secondaire de mesure (31) adapté pour entourer le conducteur de courant (2) et un enroulement secondaire de test (32) pour induire un signal de test dans l'enroulement secondaire de mesure (31) quand des impulsions de test (61) sont appliquées audit enroulement secondaire de test (32), appareil électrique (5) **caractérisé en ce qu'**il comporte :
- un circuit de traitement (11), connecté à l'enroulement secondaire de mesure (31) du transformateur de courant (3), pour fournir un signal (62) représentatif du courant électrique (Ip),
- un premier circuit de filtrage (14) du signal représentatif du courant électrique (62), connecté au circuit de traitement (11), pour fournir un premier signal filtré (P) dans une première bande de fréquences (BF1),
- un circuit générateur d'impulsions (10) connecté à l'enroulement secondaire de test (32) du transformateur de courant (3) pour générer les impulsions de test (61) dans l'enroulement secondaire de test (32) à une fréquence de test prédéfinie (Ft) contenue dans une deuxième bande de fréquences (BF2), et
- un deuxième circuit de filtrage (15) du signal représentatif du courant électrique (62), connecté au circuit de traitement (11), pour fournir un deuxième signal (T) filtré dans la deuxième bande de fréquences (BF2).

2. Appareil électrique (5) selon la revendication 1 **caractérisé en ce que** l'enroulement secondaire de mesure (31) est bobiné en suivant un premier axe d'enroulement circulaire (36), l'enroulement secondaire de test (32) est bobiné en suivant un second axe d'enroulement circulaire (35), les premiers et seconds axes circulaires (35, 36) ayant un même centre (37) et étant disposés dans un même plan (39).

3. Appareil électrique (5) selon la revendication 1 **caractérisé en ce que** l'enroulement secondaire de mesure (31) est composé d'au moins un premier tronçon d'enroulement de mesure (31a) et que l'enroulement secondaire de test (32) est composé d'au moins un premier tronçon d'enroulement de test (32a), les premiers tronçons d'enroulement de mesure et de test (31a, 32a) ayant un même axe d'enroulement (X-X').

4. Appareil électrique (5) selon l'une quelconque des revendications précédentes, **caractérisé en ce que** :
- l'enroulement secondaire de mesure (31) est formé d'au moins une première portion réalisée au moyen d'un premier support (38a), et d'une seconde portion réalisée au moyen d'un second support (38b), la seconde portion étant bobinée en sens inverse de la première portion, la première et la seconde portion d'enroulement étant reliées en série,
- l'enroulement secondaire de test (32) est formé d'au moins une première portion réalisée au moyen du premier support (38a), et d'une seconde portion réalisée au moyen du second support (38b), la seconde portion étant bobinée en sens inverse de la première portion, la première et la seconde portion d'enroulement secondaire de test étant reliées en série, et que,
- le premier et le second support (38a, 38b) sont disposés côte-à-côte de façon à ce que les axes d'enroulement de la première portion et de la seconde portion d'enroulement secondaire de mesure soient parallèles et que les axes d'enroulement de la première portion et de la seconde portion d'enroulement secondaire de test soient parallèles.

5. Appareil électrique (5) selon la revendication précédente **caractérisé en ce que** le premier et le second support (38a, 38b) sont réalisés au moyen de circuit imprimé.

6. Appareil électrique (5) selon l'une quelconque des revendications précédentes **caractérisé en ce que** la deuxième bande de fréquences (BF2) est supérieure à la première bande de fréquences (BF1).

7. Appareil électrique (5) selon l'une quelconque des revendications précédentes **caractérisé en ce que** le circuit de traitement (11) échantillonne le signal représentatif du courant électrique (62) à une fréquence d'échantillonnage (Fs) supérieure à la fréquence de test (Ft).

8. Appareil électrique (5) selon la revendication précédente **caractérisé en ce que** la fréquence d'échantillonnage (Fs) est sensiblement égale à trois fois la fréquence de test (Ft).

9. Appareil électrique (5) selon la revendication précédente **caractérisé en ce que** la fréquence de test (Ft) est comprise entre 800 et 2000 Hz.

10. Appareil électrique (5) selon l'une quelconque des revendications précédentes **caractérisé en ce qu'**il comporte un circuit de surveillance (54), connecté au deuxième circuit de filtrage (15), pour recevoir le deuxième signal filtré (T) et pour générer une alerte (AL) quand l'amplitude du deuxième signal filtré (T) est inférieure à un seuil d'alerte (Sal) prédéfini.

11. Appareil électrique (5) selon l'une quelconque des revendications précédentes **caractérisé en ce que** les impulsions de test (61) sont générées par dérivation d'un signal carré (60) émis par un générateur de signal carré (18).

12. Appareil électrique (5) selon la revendication précédente **caractérisé en ce qu'**un circuit de contrôle (17), connecté à l'enroulement secondaire de test (32), active un signal de contrôle (C) quand la forme de la tension (Vbob) aux bornes de l'enroulement secondaire de test (32) est identique à la forme du signal carré (60) émis pas le générateur de signal carré (18).

13. Appareil électrique (5) selon la revendication précédente **caractérisé en ce que** le circuit de surveillance (54) est connecté au circuit de contrôle (17) pour recevoir le signal de contrôle (C) et pour générer l'alerte (AL) quand le signal de contrôle (C) est actif.

14. Appareil électrique (5) selon l'une quelconque des revendications précédentes, comportant :
- un interrupteur de courant (51) pour établir ou pour interrompre la circulation du courant électrique (Ip) dans, au moins, le conducteur de courant (2),
- un actionneur (52) pour actionner l'ouverture de l'interrupteur de courant (51), et
- un circuit de protection (53), connecté au premier circuit de filtrage (14) pour recevoir le premier signal filtré (P)
**caractérisé en ce que** le circuit de protection (53) comporte au moins un seuil de déclenchement (Sd) et active l'actionneur quand le premier signal filtré (P) est supérieur au seuil de déclenchement (Sd).

15. Appareil électrique (5) selon l'une quelconque des revendications précédentes **caractérisé en ce qu'**il comporte un circuit de mesure (55), connecté à un troisième circuit de filtrage (16) pour recevoir un troisième signal filtré (M) et pour fournir une mesure du troisième signal filtré (M).

## Patentansprüche

1. Elektrisches Gerät (5) aufweisend einen Rogowski-Stromwandler (3) zur Messung eines Stroms (Ip), der in einem Stromleiter (2) fließt, der einen Primärkreis bildet, wobei der Stromwandler (3) eine Mess-Sekundärwicklung (31), die geeignet ist, den Stromleiter (2) zu umgeben, und eine Test-Sekundärwicklung (32) aufweist, um ein Testsignal in der Mess-Sekundärwicklung (31) zu induzieren, wenn Testimpulse (61) an die Test-Sekundärwicklung (32) angelegt sind, wobei das elektrische Gerät (5) **dadurch gekennzeichnet ist, dass** es Folgendes aufweist:
- einen Verarbeitungskreis (11), der an die Mess-Sekundärwicklung (31) des Stromwandlers (3) angeschlossen ist, um ein Signal (62) bereitzustellen, das für den elektrischen Strom (Ip) repräsentativ ist,
- einen ersten Kreis zur Filterung (14) des Signals, das für den elektrischen Strom repräsentativ ist (62), der an den Verarbeitungskreis (11) angeschlossen ist, um ein erstes gefiltertes Signal (P) in einem ersten Frequenzband (BF1) bereitzustellen,
- einen Impulserzeugungskreis (10), der an die Test-Sekundärwicklung (32) des Stromwandlers (3) angeschlossen ist, um Testimpulse (61) in der Test-Sekundärwicklung (32) bei einer vorgegebenen Testfrequenz (Ft) zu erzeugen, die in einem zweiten Frequenzband (BF2) liegt, und
- einen zweiten Kreis zur Filterung (15) des Signals, das für den elektrischen Strom repräsentativ ist (62), der an den Verarbeitungskreis (11) angeschlossen ist, um ein zweites gefiltertes Signal (T) im zweiten Frequenzband (BF2) bereitzustellen.

2. Elektrisches Gerät (5) nach Anspruch 1, **dadurch gekennzeichnet, dass** die Mess-Sekundärwicklung (31) entlang einer ersten kreisförmigen Wicklungsachse (36) gewickelt ist, die Test-Sekundärwicklung (32) entlang einer zweiten kreisförmigen Wicklungsachse (35) gewickelt ist, wobei die ersten und zweiten kreisförmigen Achsen (35, 36) ein und denselben Mittelpunkt (37) aufweisen und in ein und derselben Ebene (39) angeordnet sind.

3. Elektrisches Gerät (5) nach Anspruch 1, **dadurch gekennzeichnet, dass** die Mess-Sekundärwicklung (31) aus wenigstens einem ersten Mess-Wicklungsteilstück (31a) zusammengesetzt ist und die Test-Sekundärwicklung (32) aus wenigstens einem ersten Test-Wicklungsteilstück (32a) zusammengesetzt ist, wobei die ersten Mess- und Test-Wicklungsteilstücke (31a, 32a) ein und dieselbe Wicklungsachse (X-X') aufweisen.

4. Elektrisches Gerät (5) nach einem der vorhergehenden Ansprüche, **dadurch gekennzeichnet, dass**:
- die Mess-Sekundärwicklung (31) von wenigstens einem ersten Abschnitt, der mittels eines ersten Trägers (38a) hergestellt ist, und einem zweiten Abschnitt gebildet ist, der mittels eines zweiten Trägers (38b) hergestellt ist, wobei der zweite Abschnitt in entgegengesetzter Richtung zum ersten Abschnitt gewickelt ist, wobei der erste und zweite Wicklungsabschnitt in Reihe geschaltet sind,
- die Test-Sekundärwicklung (32) von wenigstens einem ersten Abschnitt, der mittels des ersten Trägers (38a) hergestellt ist, und einem zweiten Abschnitt gebildet ist, der mittels des zweiten Trägers (38b) hergestellt ist, wobei der zweite Abschnitt in entgegengesetzter Richtung zum ersten Abschnitt gewickelt ist, wobei der erste und zweite Test-Sekundärwicklungsabschnitt in Reihe geschaltet sind, und dass,
- der erste und zweite Träger (38a, 38b) Seite an Seite angeordnet sind, damit die Wicklungsachsen des ersten und des zweiten Mess-Sekundärwicklungsabschnitts parallel sind und die Wicklungsachsen des ersten und des zweiten Test-Sekundärwicklungsabschnitts parallel sind.

5. Elektrisches Gerät (5) nach dem vorhergehenden Anspruch, **dadurch gekennzeichnet, dass** der erste und zweite Träger (38a, 38b) mittels einer gedruckten Schaltung hergestellt sind.

6. Elektrisches Gerät (5) nach einem der vorhergehenden Ansprüche, **dadurch gekennzeichnet, dass** das zweite Frequenzband (BF2) größer als das erste Frequenzband (BF1) ist.

7. Elektrisches Gerät (5) nach einem der vorhergehenden Ansprüche, **dadurch gekennzeichnet, dass** der Verarbeitungskreis (11) das Signal, das für den elektrischen Strom repräsentativ ist (62), mit einer Abtastfrequenz (Fs) abtastet, die höher als die Testfrequenz (Ft) ist.

8. Elektrisches Gerät (5) nach dem vorhergehenden Anspruch, **dadurch gekennzeichnet, dass** die Abtastfrequenz (Fs) im Wesentlichen gleich dem Dreifachen der Testfrequenz (Ft) ist.

9. Elektrisches Gerät (5) nach dem vorhergehenden Anspruch, **dadurch gekennzeichnet, dass** die Testfrequenz (Ft) zwischen 800 und 2000 Hz beträgt.

10. Elektrisches Gerät (5) nach einem der vorhergehenden Ansprüche, **dadurch gekennzeichnet, dass** es einen Überwachungskreis (54) aufweist, der an den zweiten Filterungskreis (15) angeschlossen ist, um das zweite gefilterte Signal (T) zu empfangen und einen Alarm (AL) zu erzeugen, wenn die Amplitude des zweiten gefilterten Signals (T) kleiner als eine vorgegebene Alarmschwelle (Sal) ist.

11. Elektrisches Gerät (5) nach einem der vorhergehenden Ansprüche, **dadurch gekennzeichnet, dass** die Testimpulse (61) durch Ableitung eines Rechtecksignals (60) erzeugt werden, das von einem Rechtecksignalgenerator (18) ausgesendet wird.

12. Elektrisches Gerät (5) nach dem vorhergehenden Anspruch, **dadurch gekennzeichnet, dass** ein Steuerkreis (17), der an die Test-Sekundärwicklung (32) angeschlossen ist, ein Steuersignal (C) aktiviert, wenn die Form der Spannung (Vbob) an den Anschlüssen der Test-Sekundärwicklung (32) mit der Form des Rechtecksignals (60) identisch ist, das vom Rechtecksignalgenerator (18) ausgesendet wird.

13. Elektrisches Gerät (5) nach dem vorhergehenden Anspruch, **dadurch gekennzeichnet, dass** der Überwachungskreis (54) an den Steuerkreis (17) angeschlossen ist, um das Steuersignal (C) zu empfangen und den Alarm (AL) zu erzeugen, wenn das Steuersignal (C) aktiv ist.

14. Elektrisches Gerät (5) nach einem der vorhergehenden Ansprüche, aufweisend:
- einen Stromschalter (51) zur Herstellung oder Unterbrechung des Flusses des elektrischen Stroms (Ip) wenigstens in dem Stromleiter (2),
- einen Betätiger (52) zur Herbeiführung der Öffnung des Stromschalters (51), und
- einen Schutzkreis (53), der an den ersten Filterungskreis (14) angeschlossen ist, um das erste gefilterte Signal (P) zu empfangen,
**dadurch gekennzeichnet, dass** der Schutzkreis (53) wenigstens eine Auslöseschwelle (Sd) aufweist und den Betätiger aktiviert, wenn das erste gefilterte Signal (P) höher als die Auslöseschwelle (Sd) ist.

15. Elektrisches Gerät (5) nach einem der vorhergehenden Ansprüche, **dadurch gekennzeichnet, dass** es einen Messkreis (55) aufweist, der an einen dritten Filterungskreis (16) angeschlossen ist, um ein drittes gefiltertes Signal (M) zu empfangen und eine Messung des dritten gefilterten Signals (M) bereitzustellen.

## Claims

1. Electrical device (5) including a Rogowski current transformer (3), intended to measure a current (Ip) flowing through a current conductor (2) forming a primary circuit, said current transformer (3) including a measurement secondary winding (31) designed to surround the current conductor (2), and a test secondary winding (32) for inducing a test signal in the measurement secondary winding (31) when test pulses (61) are applied to said test secondary winding (32), which electrical device (5) is **characterized in that** it includes:
- a processing circuit (11), connected to the measurement secondary winding (31) of the current transformer (3), in order to supply a signal (62) representative of the electric current (Ip),
- a first circuit (14) for filtering the signal representative of the electric current (62), connected to the processing circuit (11), in order to supply a first filtered signal (P) in a first frequency band (BF1),
- a pulse generator circuit (10) connected to the test secondary winding (32) of the current transformer (3) in order to generate the test pulses (61) in the test secondary winding (32) at a predefined test frequency (Ft) contained in a second frequency band (BF2), and
- a second circuit (15) for filtering the signal representative of the electric current (62), connected to the processing circuit (11), in order to supply a second filtered signal (T) in the second frequency band (BF2).

2. Electrical device (5) according to Claim 1, **characterized in that** the measurement secondary winding (31) is wound along a first circular winding axis (36), the test secondary winding (32) is wound along a second circular winding axis (35), the first and second circular axes (35, 36) having one and the same centre (37) and being arranged in one and the same plane (39).

3. Electrical device (5) according to Claim 1, **characterized in that** the measurement secondary winding (31) is formed of at least one first measurement winding section (31a) and that the test secondary winding (32) is formed of at least one first test winding section (32a), the first measurement and test winding sections (31a, 32a) having one and the same winding axis (X-X').

4. Electrical device (5) according to any one of the preceding claims, **characterized in that**:
- the measurement secondary winding (31) is formed of at least one first portion formed by way of a first support (38a), and of a second portion formed by way of a second support (38b), the second portion being wound in the opposite direction to the first portion, the first and the second winding portion being connected in series,
- the test secondary winding (32) is formed of at least one first portion formed by way of the first support (38a), and of a second portion formed by way of the second support (38b), the second portion being wound in the opposite direction to the first portion, the first and the second test secondary winding portion being connected in series, and **in that**
- the first and the second support (38a, 38b) are arranged side-by-side such that the winding axes of the measurement secondary winding first portion and second portion are parallel and that the winding axes of the test secondary winding first portion and second portion are parallel.

5. Electrical device (5) according to the preceding claim, **characterized in that** the first and the second support (38a, 38b) are formed by way of a printed circuit.

6. Electrical device (5) according to any one of the preceding claims, **characterized in that** the second frequency band (BF2) is higher than the first frequency band (BF1).

7. Electrical device (5) according to any one of the preceding claims, **characterized in that** the processing circuit (11) samples the signal representative of the electric current (62) at a sampling frequency (Fs) higher than the test frequency (Ft).

8. Electrical device (5) according to the preceding claim, **characterized in that** the sampling frequency (Fs) is substantially equal to three times the test frequency (Ft).

9. Electrical device (5) according to the preceding claim, **characterized in that** the test frequency (Ft) is between 800 and 2000 Hz.

10. Electrical device (5) according to any one of the preceding claims, **characterized in that** it includes a surveillance circuit (54), connected to the second filtering circuit (15), in order to receive the second filtered signal (T) and in order to generate a warning (AL) when the amplitude of the second filtered signal (T) is lower than a predefined warning threshold (Sal).

11. Electrical device (5) according to any one of the preceding claims, **characterized in that** the test pulses (61) are generated by tapping off a square-wave signal (60) emitted by a square-wave signal generator (18).

12. Electrical device (5) according to the preceding claim, **characterized in that** a monitoring circuit (17), connected to the test secondary winding (32), activates a monitoring signal (C) when the form of the voltage (Vbob) across the terminals of the test secondary winding (32) is identical to the form of the square-wave signal (60) emitted by the square-wave signal generator (18).

13. Electrical device (5) according to the preceding claim, **characterized in that** the surveillance circuit (54) is connected to the monitoring circuit (17) in order to receive the monitoring signal (C) and in order to generate the warning (AL) when the monitoring signal (C) is active.

14. Electrical device (5) according to any one of the preceding claims, including:
- a current switch (51) for establishing or for interrupting the flow of the electric current (Ip) through at least the current conductor (2),
- an actuator (52) for actuating the opening of the current switch (51), and
- a protective circuit (53), connected to the first filtering circuit (14) in order to receive the first filtered signal (P)
**characterized in that** the protective circuit (53) includes at least one trip threshold (Sd), and activates the actuator when the first filtered signal (P) is higher than the trip threshold (Sd).

15. Electrical device (5) according to any one of the preceding claims, **characterized in that** it includes a measurement circuit (55), connected to a third filtering circuit (16) in order to receive a third filtered signal (M) and in order to supply a measurement of the third filtered signal (M).
